Europäisches Patentamt

(19) European Patent Office

Office européen des brevets

(11) Publication number: **0 259 102**
**A2**

## (12) EUROPEAN PATENT APPLICATION

(21) Application number: **87307610.3**

(22) Date of filing: **27.08.87**

(51) Int. Cl.⁴: **H 05 K 3/34**

(30) Priority: **03.09.86 US 903234**

(43) Date of publication of application:
**09.03.88 Bulletin 88/10**

(84) Designated Contracting States: **DE FR GB NL SE**

(71) Applicant: **NORTHERN TELECOM LIMITED**
**600 de la Gauchetiere Street West**
**Montreal Quebec H3B 4N7 (CA)**

(72) Inventor: **Entwistle, Stanley Donald**
**2 Meadowbank Dr.**
**Neapan Ontario, KG2 ON9 (CA)**

**Sobolak, Timothy**
**193 Ocala Ct**
**Cary, N.C. 27511 (US)**

**Goodyear, George William Ronald**
**211A Gorman St**
**Raleigh, N.C. 27606 (US)**

(74) Representative: **Spencer, Graham Easdale et al**
**A.A. Thornton & CO Northumberland House 303-306, High Holborn**
**London WC1V 7LE (GB)**

(54) **Multi-point solder paste application.**

(57) Solder paste is automatically applied to a circuit board 10, in a predetermined pattern 11 in predetermined amounts, by filling holes 17 in a plate 15 with solder paste 19 having prescribed physical characteristics. The plate is filled from the top and then pivotted over, the paste being ejected by pins 18 in the holes 17 onto a circuit board 10. The holes 17 having defined dimensional characteristics. The paste 19 has defined percentages of metal content and physical form of metal, and a prescribed single point viscosity range. The circuit board 10 can be clamped to a datum position while being filled. Monitoring of the deposited solder paste 19 can be obtained by depositing the solder paste 19 on a substrate, for example of ceramic, and the paste fused to form balls. The size and position of the balls can then be visually monitored by a scanning apparatus in conjunction with a computer.

FIG. 5

EP 0 259 102 A2

**Description**

MULTI-POINT SOLDER PASTE APPLICATION

BACKGROUND OF THE INVENTION

Field of the Invention

This invention relates to a multi-point solder paste application, and is particularly concerned with the application of solder paste to circuit boards.

Related Art

The number of connections to be made between components and a circuit pattern has increased considerably. Surface mounting of components requires the placement of solder paste at the large number of connection positions. Our co-pending application serial number 681,265 filed December 13, 1984 describes an applicator for solder paste in which solder paste is filled into holes in a plate, the paste then being ejected from the holes onto a circuit board by pins reciprocating in the holes.

While the apparatus has enabled the application of solder paste to a large number of positions simultaneously, there is likely to be considerable variation in the amount of paste deposited at each position. Variation in deposition can occur from position to position on a circuit board. It can also occur at a particular position from board to board. Excess solder paste and insufficient solder paste both can cause unsatisfactory joints when the solder is fused. Reworking of circuit boards to rectify faulty connections can amount to up to 25% of the circuit boards handled.

SUMMARY OF THE INVENTION

The present invention enables the number of unsatisfactory joints to be reduced to a very low number. The invention resides in the use of a closely controlled solder paste having particular physical characteristics, and the use of holes, or cavities, having defined dimensional characteristics. Generally, in accordance with the invention, a solder paste having certain parameters, such as ratio of solder to total paste, viscosity characteristics, and particular physical characteristics of the solder in the paste, is filled into cavities having a preferred diameter/depth ratio, to give a solder paste deposited spot size having a required amount of solder.

Periodic inspection of the solder paste spots can be carried out. One inspection method is by providing a white ceramic substrate on which the solder paste is deposited, and fusing the solder paste to form a solder ball at each position. The substrate is then scanned and the size of each solder ball measured. Also, the position of each solder ball is determined, and both of these results compared to a datum. Differing sizes of solder paste spots, and solder balls, can be produced at different positions.

BRIEF DESCRIPTION OF THE DRAWINGS

The invention will be readily understood by the following description of certain embodiments, by way of example, in conjunction with the accompanying drawings, in which:-

Figure 1 is a diagrammatic plan view on part of one surface of a circuit board, showing a circuit pattern;

Figure 2 is a cross-section through one form of applicator, in a loading condition;

Figure 3 is a cross-section as in Figure 2, with the solder paste loaded in the applicator;

Figure 4 illustrates the applicator in the filling position and its rotation to an application position;

Figure 5 is a cross-section as in Figure 3, of one pin and hole, illustrating a modification to the applicator, the applicator in an application position;

Figure 6 is a cross-section similar to that of Figure 4, illustrating the pin in an intermediate application position;

Figure 7 is a cross-section similar to that in Figures 4 and 5, illustrating the pin in a full application position against a circuit board; and

Figure 8 illustrates a pin being withdrawn from the circuit board.

DETAILED DESCRIPTION OF THE EMBODIMENTS

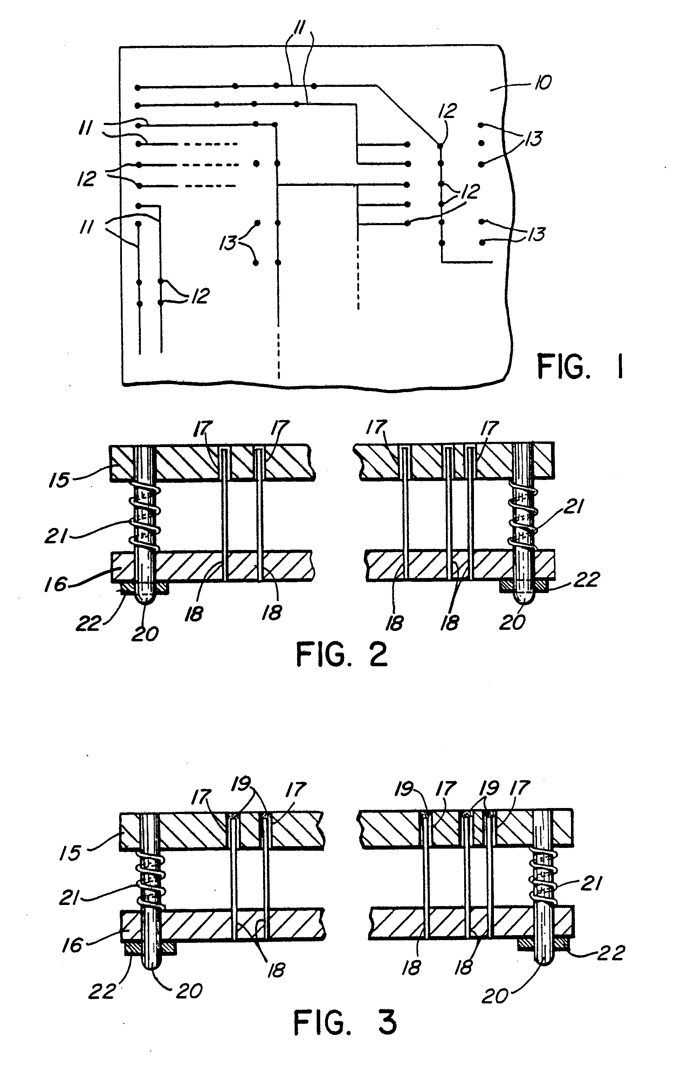

Figure 1 illustrates part of a circuit board 10 having circuit pattern 11 formed on one surface. Circuit patterns may be on one surface or on both surfaces of the board. Similarly, components can be mounted on one or both surfaces. Some components can be mounted by leads passing through holes in the board, and circuit pattern. Other components can be surface mounted in which contact areas on the components make contact with and are soldered to contact pads on the circuit. It is desirable to position dots of solder paste at solder connection positions. Such dots are indicated at 12 and 13 in Figure 1. Some dots, 12, are positioned on a circuit pattern and other dots, 13, are positioned at holes in the circuit board, the holes having annular contact areas or pads around them on the surface seen in Figure 1, but connection with circuit patterns on the other surface of the circuit board, via plated through holes.

In Figures 2 and 3, a two part die is shown, in an inverted position, having a first plate 15 and second plate 16. A plurality of holes 17 are formed in the plate 15 and a plurality of pins 18 are mounted in plate 16, a pin 18 aligned with and sliding in each hole 17. In Figure 2, the first plate 15 is in a filling or loading condition with pins 18 in a withdrawn position. In figure 3, the cavities formed by the holes 17 and pins 18 are shown filled with solder paste 19. The plate 16 reciprocates relative to plate 15, pushing out the solder paste, as indicated by the arrow in Figure 3, the plate 16 sliding on guide members 20, being biased to a withdrawn position, as in Figure 3, by springs 21. The movement of plate 16 away from plate 15 is restricted by stop members 22.

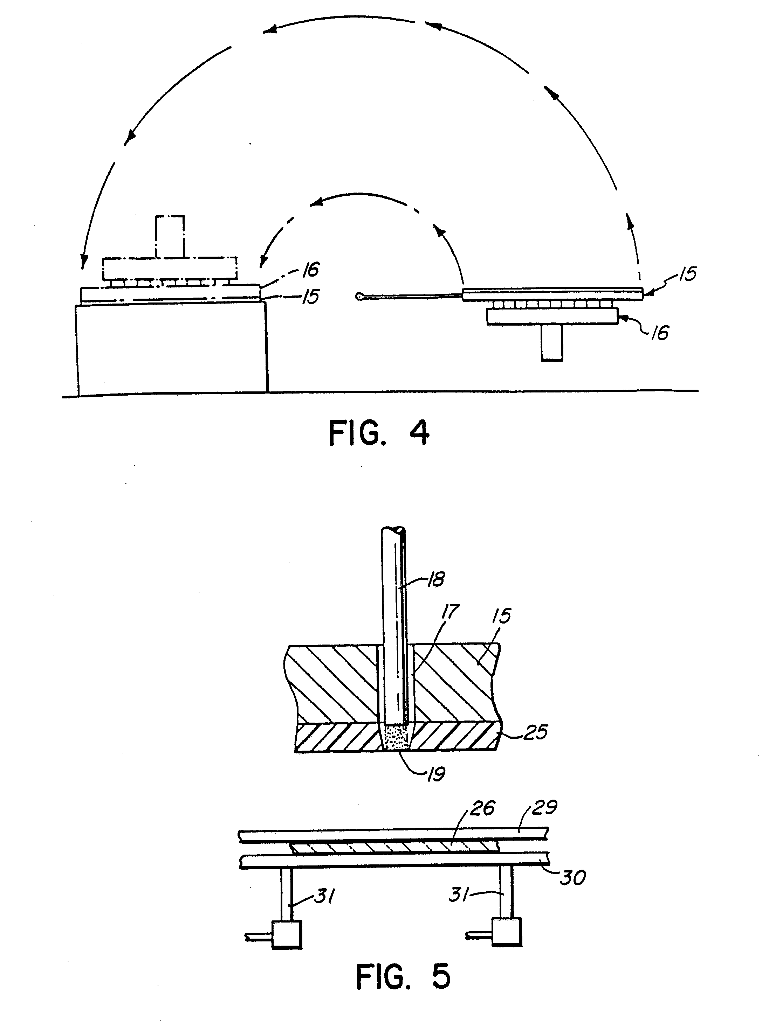

The first plate 15 has the cavities filled with solder paste in the inverted condition, as in Figures 2 and 3. The applicator is rotated over, plate 15 becoming a bottom plate. This is shown in Figure 4.

The action of one particular pin 18 is illustrated in Figures 5 to 8. Also shown in Figures 5, 6 and 7 is a modification in which a thin sheet or layer of Teflon (Trademark) 25 is mounted on the bottom surface of plate 15. This material has the characteristic in that when drilled to form a hole, when the drill is removed the hole becomes tapered, which provides a seal around the end of the pin when extended.

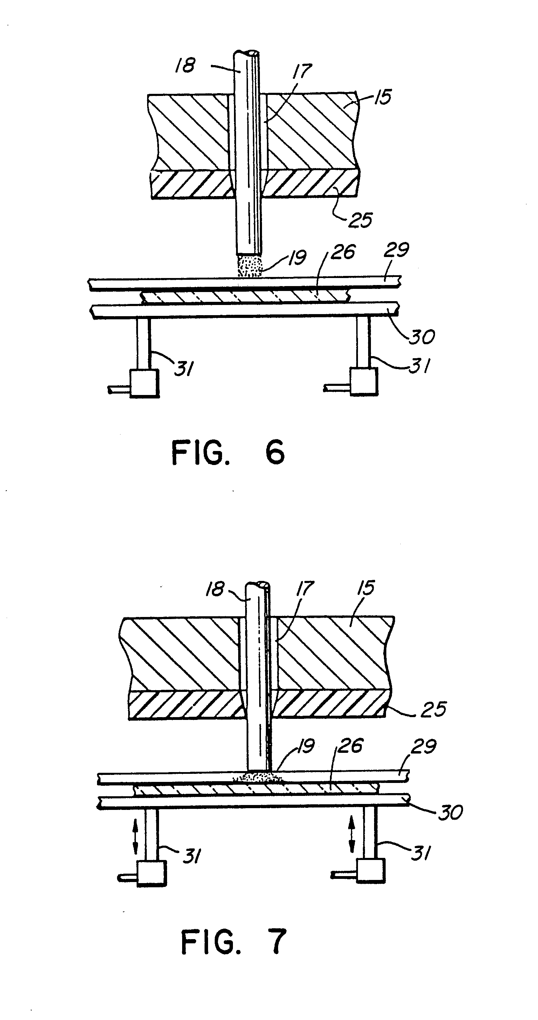

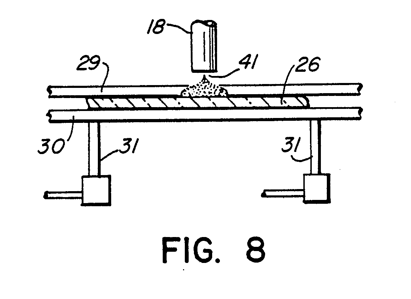

As seen in Figure 5, the lower plate 15 of the applicator is positioned a small distance above a circuit board 26. In Figure 6, pin 18 is partially pushed down pushing the deposited solder paste 19 in front, towards the circuit board. The pin moves almost into contact with the circuit board, squashing the paste onto the board, as in Figure 7. As the pin is withdrawn, the paste is pulled up into a hemispherical shape, with a small pip or neck, as at 41 in Figure 8.

A problem which can arise is that circuit boards can be warped, or otherwise not planar. Also, the thicknesses of boards can vary. To ensure that the whole top surface of a board will always be at a predetermined position, boards are moved between two sets of rails, top rails 29 and bottom rails 30. The rails extend in two parallel paths, supporting the boards at their side edges. At the paste deposition position, the bottom rails can be moved upward, as by pneumatic rams 31. This pushes the top surface of a board against the top rails 29 and ensures that the board is planar and that its top surface is at a datum position. For convenience, only the sections of bottom rails 30 beneath the solder dispensing machine need be made moveable.

The solder paste has a number of characteristics which cause problems in application. Solder paste is a mixture of a solid, in the form of a metal in particles, and a flux, which is a fluid - albeit a very viscous fluid. The paste can only be caused to move to fill cavities satisfactorily by maintaining the speed and pressure at which it is moved - the shear rate - below a limit. As the speed of fill, or shear rate, increases, it is possible to reach a condition where the cavities are filled mainly with flux, with a minor proportion of metal. The maximum shear rate is varied by the physical characteristics of the metal particles. Additives to the mixture of metal and flux also affect the paste characteristics.

There are also requirements as to the amount of solder required at a contact point and there is also a fairly close limitation on the tolerance for the solder amount. Also the physical dimensions of the holes or cavities to be filled are fairly critical. Holes deep relative to diameter are difficult to fill and may also cause a high shear rate, resulting in the paste containing too much flux relative to metal.

The ratio between maximum and minimum paste is about 2:1, minimum being the actual amount of paste to form a satisfactory joint. This actual amount is usually well known, depending largely upon the size of component. The amount of solder provided at a joint should be sufficient to give a .001" (25 micron) gap between component and board mounting pad and give a visual showing of solder fillet about 1/3 up the end of the component terminal metalization or component lead. With this minimum, the maximum amount of paste is about twice this. Less than the minimum does not leave the component clear of the mounting pads, with the possibility of an incomplete solder joint, for example minimal lap joint and fillet strength. Too much solder can cause a variety of problems. One is referred to as "bookending" in which solder extends up the end and over the top of the component. This can cause failure of the joint due to thermal mismatch during solidification and subsequently in service. Excess solder can also result in flux entrapment beneath components, and cannot readily be removed. Also, too much solder at one end of a component can cause lifting of the other end because of surface tension (referred to as "tombstoning").

The solder must have a predetermined proportion of metal content, typically about 88.5% metal by weight and about 50% by volume. The solder metal is in the form of spheres of the order of 45 to 75 μm diameter. The size of the spheres is determined by the volume of metal required in the paste and the desired viscosity and shear rate characteristics.

The above parameters - proportion of metal content and sphere size given above - presets to a large extent the viscosity range, generally in the range of 200,000 to 600,000 CPS. By modifying the diameter of the spheres and the rheology of the paste (physical characteristics) including use of additives, the viscosity can be tuned to a range within about 250,000 ± 50,000.

The viscosity sets a limit to the speed of filling a cavity, or hole. A ratio of diameter to depth of about 1:1 is about the minimum. This is due both to actually getting material into the cavity to fill it in a reasonable time and to ensuring that the proportion of "solids" to "liquids" is correct. The proportion of "solids" to "liquids" will vary with filling speed - referred to as rate of shear, or shear rate. The maximum ratio of cavity diameter to cavity depth is set to some extent by the amount of paste which remains attached to the end of the pin. This amount is likely to vary from stroke to stroke of the pin. With a relatively large diameter, this variation can become a significant portion of the actual deposit. A ratio of about 2:1 for diameter relative to depth is considered to be a maximum. A problem can also arise with small pins in that sufficient surface tension may not be present to hold the correct amount of solder paste on the circuit board when the pin withdraws. The diameter of the pin, with the commensurate diameter of hole or cavity, affects the diameter of the paste spot. A spot of too large a diameter can cause bridging to an adjacent circuit path or contact pad. Another problem with too large a diameter spot giving too thin a spot - is the inability to properly coalesce the solder on fusion. Another feature affecting the filling of cavities is the ability of air in the cavities being able to escape when the paste is pushed in. The pins are a relatively close sliding fit in the holes 17. The clearance is such that air can escape past the pins but solder paste does not flow into the clearance, because of surface tension for example.

The holes or cavities are filled by squeezing the paste through a stencil screen, i.e. screen printing. The paste is pushed over the cavities by a standard screen printing squeegee having a leading face which has both a forward facing component and a downward facing component, generally at about 45°. The rate at which the squeegee passes over the cavities affects filling time and also shear rate and other parameters, as mentioned above. A speed of about 5.0 cm per second has been found satisfactory. A Brookfield Helepath "single point" determination is used to give an initial viscosity value, for example, to above mentioned 250,000 ± CPS 50,000 CPS. As soon as the paste starts to move, under the action of the squeegee, this drops to between about 200,000 and 170,000 CPS. The viscosity changes with shear rate, the shear rate being stated in "inverse second" units. The characteristics of a paste can be given by three points on a curve and typical approximate values are $1.5 \ s^{-1}$, 200,000-230,000 poise; $5 \ s^{-1}$, 90,000-100,000 poise; and $9 \ s^{-1}$, 60,000-70,000 poise. These values are for a constant temperature and obtained using a Hake cone and plate viscometer.

The size of solder paste spots may vary over the board to specific requirements. Thus a single size of spot may be produced at all positions, two sizes of spot may be produced, or three sizes of spot. Spot size required will vary, as stated, depending upon component size. Also if a multi-leaded component is to be surface mounted, a different spot size is likely to be needed. Such different sizes can be obtained by providing different hole sizes in the plate, with related different pin sizes.

The spot size of the various solder connections can be verified by an automated viewing and measuring apparatus. For such checking, a substrate, for example a ceramic substrate, is put through the process and the solder paste fused to the ball stage. The substrate is viewed by a CCD camera which, in an example, has a view area composed of 1024 pixels in each axis. The camera scans the substrate in successive steps, detecting and measuring each ball. These results are compared with a master datum. Thus any missing balls are detected and also any balls falling outside the desired range. By carrying out this checking on a regular basis, it can indicate variations due to wear, clogging of pins, and other causes. This provides a quality control.

To give consistent results, careful support of the substrate during fusion of the solder is desirable, to avoid vibration. Fusion can be carried out under a slight vacuum, back filled with nitrogen to prevent oxidation. The substrate is cleaned after fusion to remove any residual flux, to give good viewing of the solder balls.

By close control of the solder paste characteristics, having cavities within the above-mentioned dimension ratios, and using suitable, predetermined, rate of shear to fill the cavities, it has been possible to produce circuit boards having solder paste spots thereon with less than 50 spots per million outside the desired size. It is not necessarily a fact that those falling outside the desired size would be electrically at fault when a component was soldered.

## Claims

1. A method of applying solder paste 19 in predetermined amounts to a circuit board 10 at a plurality of positions, comprising:
filling solder paste 19 into holes 17 in a plate 15, from a top surface of said plate 15, said solder paste 19 having prescribed physical characteristics, said holes 17 being in a predetermined pattern and each hole 17 having defined dimensional characteristics;
pivotting said plate 15 to present said top surface of the plate, in a downward direction, towards a surface of a circuit board 10; and
ejecting the solder paste 19 from said holes 17 onto said surface of said circuit board.

2. A method as claimed in claim 1, the ratio between minimum solder paste and maximum solder paste being about 2:1, the minimum paste being that amount to form a satisfactory joint.

3. A method as claimed in claim 3, said minimum paste being the amount to give a .001 inches clearance between component and a mounting pad 13 on the circuit board and to give a visual showing of solder about one third way up the component connection member.

4. A method as claimed in claim 1, the solder paste having a metal content of between about 85% and 90% by weight and about 48% and 52% by volume.

5. A method as claimed in claim 4, the metal content being about 88.5% by weight and about 50% by volume.

6. A method as claimed in claim 4, the metal being in the form of spheres of the order of 45 to 75 μm diameter.

7. A method as claimed in claim 1, said solder paste having a single point viscosity value of between about 200,000 and 600,000 CPS.

8. A method as claimed in claim 7, said single point viscosity value being about 250,000 ± 50,000 CPS.

9. A method as claimed in claim 1, said holes having a ratio of cavity diameter to cavity depth of about 2:1.

10. A method as claimed in claim 1, including pushing said solder paste 19 through a stencil screen by a squeegee.

11. A method as claimed in claim 10, said squeegee moved over said screen at a speed of about 5 cm per second.

12. A method as claimed in claim 1, including fusing said solder paste to form a plurality of solder balls, a ball at each said position; and scanning said surface and determining the size and position of each solder ball.

13. A method as claimed in claim 1, including substituting a white ceramic substrate for said circuit board; fusing said solder paste after deposition of the solder paste to form solder balls, a ball at each position; and scanning the substrate to determine the size and relative position of each solder ball.

14. Apparatus for applying solder paste to a plurality of positions on a surface of a circuit board 10, comprising:

a plate 15 having a plurality of holes 17, said holes being in a predetermined pattern and each hole having defined dimensional characterisitics;

means for filling solder paste 19 into said holes from a top surface of said plate, said solder paste having prescribed physical characteristics;

means (Figure 4) for pivotting said plate to present said top surface in a downward facing direction to said surface of said circuit board, at a hole filling position;

means 18 for ejecting said solder paste from said holes onto said surface of said circuit board; and

means for moving circuit boards sequentially to said hole filling position.

15. Apparatus as claimed in claim 14, said means for filling said solder paste into said holes including a stencil screen and a squeegee for pushing said solder paste through said screen into said holes.

16. Apparatus as claimed in claim 14, said means for ejecting said solder comprising pins 18 reciprocally mounted in said holes.

17. Apparatus as claimed in claim 14, including a bottom guide rail 30 extending beneath each side edge of said circuit board, said rails 29, 30 extending in the direction of movement of said circuit board, support rails 29 positioned above each side edge of said circuit board; and

means for moving said guide rails 30 upward towards said support rails 29 to clamp said circuit board between said guide rails and said support rails at the filling position, said surface of said circuit board being at a predetermined distance from the plate during filling.

18. Apparatus as claimed in claim 14, including means for fusing said solder paste to a ball at each of said positions, and means for scanning the solder balls to determine the size and relative position of each ball.

0259102

FIG. 1

FIG. 2

FIG. 3

0259102

FIG. 4

FIG. 5

FIG. 6

FIG. 7

0259102

FIG. 8